**Europäisches Patentamt**

**European Patent Office**

**Office européen des brevets**

(11) Veröffentlichungsnummer: **0 053 258**
**B1**

(12) **EUROPÄISCHE PATENTSCHRIFT**

(45) Veröffentlichungstag der Patentschrift:
04.04.84

(21) Anmeldenummer: **81108476.3**

(22) Anmeldetag: **19.10.81**

(51) Int. Cl.³: **G 03 C 1/80,** G 03 C 1/68,
G 03 C 1/70, G 03 C 1/727,
G 03 F 7/02, G 03 F 7/16 //
B41N1/06, B41N1/12

(54) Lichtempfindliches Mehrschichtenmaterial und Verfahren zur Herstellung von Haftschichten dafür.

(30) Priorität: **03.12.80 DE 3045515**

(43) Veröffentlichungstag der Anmeldung:
**09.06.82 Patentblatt 82/23**

(45) Bekanntmachung des Hinweises auf die Patenterteilung:
**04.04.84 Patentblatt 84/14**

(84) Benannte Vertragsstaaten:
**BE CH DE FR GB IT LI NL**

(56) Entgegenhaltungen:
**Keine**

(73) Patentinhaber: **BASF Aktiengesellschaft,
Carl-Bosch-Strasse 38, D-6700 Ludwigshafen (DE)**

(72) Erfinder: **Hoffmann, Gerhard, Dr., Pappelstrasse 22,
D-6701 Otterstadt (DE)**
Erfinder: **Bronstert, Bernd, Dr., Sonnenstrasse 12B,
D-6710 Frankenthal (DE)**
Erfinder: **Hahn, Herbert, Dr., Ungsteiner Strasse 41,
D-6700 Ludwigshafen (DE)**
Erfinder: **Jun, Mong-Jon, Dr., Maulbeerstueck 20,
D-6720 Speyer (DE)**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

# Lichtempfindliches Mehrschichtenmaterial und Verfahren zur Herstellung von Haftschichten dafür

Die Erfindung betrifft als photopolymere Druckplatten geeignete lichtempfindliche Mehrschichtenmaterialien, die zwischen Trägerschicht und einer lichtempfindlichen Schicht mit Bindemittel und photopolymerisierbaren ethylenisch ungesättigten Verbindungen spezielle Haftschichten aufweisen sowie ein Verfahren zur Herstellung solcher Haftschichten.

Es ist z. B. aus der DE-A-2 202 357 bekannt, photopolymere Reliefschichten für Druckformen durch spezielle Haftschichten auf den Trägerschichten fest zu verankern. Hierbei wird nach Beschichten der Träger, z. B. der Stahl- oder Aluminiumbleche, mit einer Grundierlackschicht (HG) zur verbesserten Haftung mit der reliefbildenden lichtempfindlichen Schicht eine Haftschicht HO durch schichtförmiges Auftragen und Trocknen bzw. Einbrennen eines Lackes (OL) hergestellt, der eine härtbare Mischung eines Bindemittels enthält, das mit dem polymeren Bindemittel der reliefbildenden Schicht verträglich ist. Für das Einbrennen bzw. Härten der Haftschichten HO ist jedoch die Anwendung hoher Temperaturen erforderlich, was einerseits einen hohen Energieaufwand mit entsprechend hohen Herstellkosten bedeutet, andererseits die Verwendung mancher Trägermaterialien nicht gestattet, da sie die Wärmebehandlung ohne starke Beeinträchtigung ihrer Eigenschaften nicht überstehen. Dies gilt z. B. für die Herstellung von photopolymeren Druckplatten mit Polyesterfolien als Trägerschichten. Es ist zwar bekannt, die Härtungstemperatur von härtbaren Formaldehyd-Harzen durch Zugabe von Säuren als Katalysatoren herabzusetzen, doch eignen sich solche katalysierten Harze wegen ihrer geringen Topfzeit nicht zur Herstellung gleichmäßiger Lackierungen und einheitlicher dünner Haftschichten.

Der vorliegenden Erfindung lag die Aufgabe zugrunde, ein verbessertes Verfahren zur Herstellung solcher Haftschichten für lichtempfindliche Mehrschichtenmaterialien zu finden, das die Herstellung dauerhafter und lösungsmittelresistenter Haftschichten auch bei Temperaturen unter 100°C gestattet und das auch für die Herstellung von Mehrschichtenmaterialien mit Kunststoff-Trägerfolien verwendbar ist. .

Es wurde nun gefunden, daß die vorgenannte Aufgabe gelöst werden kann, wenn der Lack (OL) für die Herstellung der der reliefbildenden lichtempfindlichen Schicht R benachbarten Haftschicht HO als Bindemittel eine Mischung aus

(A1)     65 bis 98 Gew.-% eines mit dem Bindemittel der Schicht R und dem Kondensat (A2) verträglichen Bindemittels und

(A2)     2 bis 35 Gew.-% eines bei 60 bis 120°C härtbaren 1 bis 5 Melamin-Einheiten enthaltenden Melamin-Formaldehyd-Kondensats mit einem Methylolierungsgrad des Melamins von 40 bis 100%, wobei 10 bis 60% der Methylolgruppen mit Alkohol verethert sind, enthält

und die Mischung nach dem Auftragen der Lackschicht durch Erwärmen gehärtet wird.

Gegenstand der Erfindung ist neben dem Verfahren zur Herstellung solcher Haftschichten ferner ein lichtempfindliches Mehrschichtenmaterial, das zwischen

(a) einer gegebenenfalls mit einer Grundierlackschicht (HG) versehenen Trägerschicht (T) und

(b) einer lichtempfindlichen Schicht R mit einer Fotoinitiator enthaltenden Mischung von mindestens einem Bindemittel und mindestens einer damit verträglichen fotopolymerisierbaren ethylenisch ungesättigten Verbindung,

(c) eine der lichtempfindlichen Schicht R benachbarte Haftschicht HO mit einer gehärteten Mischung eines Bindemittels aufweist, das dadurch gekennzeichnet ist, daß die Haftschicht HO eine gehärtete Mischung aus

(A1)     65 bis 98 und insbesondere 80 bis 90 Gew.-% eines mit dem Bindemittel der Schicht R und dem Kondensat (A2) verträglichen Bindemittels und

(A2)     2 bis 35 und insbesondere 10 bis 20 Gew.-% eines bei 60 bis 120°C und bevorzugt bei 70 bis 90°C ohne Säurekatalyse härtbaren 1 bis 5 Melamin-Einheiten enthaltenden Melamin-Formaldehyd-Kondensats mit einem Methylolierungsgrad des Melamins von 40 bis 100%, wobei 10 bis 60% der Methylolgruppen mit Alkohol verethert sind, enthält.

Ein wesentliches Merkmal der Erfindung ist die Anwendung des Kondensats A2 für die Haftschicht, das eine Härtung ohne Säurekatalyse in den genannten niedrigen Temperaturbereichen gestattet. Das härtbare Formaldehydkondensat oligomerer und bevorzugt monomerer Art, wird aus Melamin und Formaldehyd so hergestellt, daß der Methylolierungsgrad des Melamins zwischen 40 und 100% und bevorzugt bei 60 bis 80% liegt und 10 bis 60, bevorzugt 20 bis 50% der Methylolgruppierungen mit Alkoholen, insbesondere Alkoholen mit 1 bis 4 C-Atomen verethert sind. Die mittleren Molekulargewichte sehr geeigneter Kondensate liegen bei etwa 240 bis 1800.

Bewährt haben sich als Kondensat besonders die Mono- und Di-$C_1$—$C_4$-alkylether des Tetramethylolmelamins, insbesondere die entsprechenden Methylether sowie entsprechend strukturierte partielle Ether von Methylolgruppen tragenden Melamin-Formaldehyd-Kondensaten mit bis zu 5 Melaminresten im Molekül.

Als Bindemittel A1 für die härtbare Mischung werden solche verwandt, die einerseits mit den vorstehenden Kondensaten verträglich sind, zum anderen zur Erzielung einer guten Haftung mit der reliefbildenden lichtempfindlichen Schicht R mit dem oder den in der Schicht R verwendeten Bindemitteln verträglich sind. Meist hat es sich so als zweckmäßig erwiesen, das gleiche oder zumindest ein sehr ähnlich strukturiertes polymeres Bindemittel für die Haftschicht HO wie für die lichtempfindliche Schicht R zu verwenden.

Als polymere Bindemittel für die lichtempfindliche Schicht R eignen sich praktisch alle in der Literatur für die Herstellung photopolymerer Druckplatten oder Reliefformen angegebenen Polymerbindemittel. Genannt seien Polyamide und besonders alkohollösliche Copolyamide, wie sie in der FR-A-1 520 856 beschrieben sind, Cellulosederivate, insbesondere wäßrig-alkalisch auswaschbare Cellulosederivate, Vinylalkohol-Polymere und Polymere und Copolymere von Vinylestern aliphatischer Monocarbonsäuren mit 1 bis 4 C-Atomen, wie von Vinylacetat, mit unterschiedlichem Verseifungsgrad, Homo- und Copolymerisate des Vinylpyrrolidons, des Vinylchlorids oder des Styrols, Polyurethane, Polyätherurethane, Polyesterurethane, Polyesterharze, Acryl- sowie Methacrylsäureester-Copolymere wie Copolymere des Methylmethacrylats mit Acrylsäure, Methacrylsäure, Acrylamid und/oder Hydroxyalkyl(meth)acrylaten, und elastomere Dien-Polymere und -Copolymere wie Blockcopolymere aus Butadien- und/oder Isopren-Homopolymerblöcken und Polymerblöcken aus Styrol oder α-Methylstyrol. Sie liegen in den Schichten R in bekannter Art in Mischung mit ein oder mehreren damit verträglichen fotopolymerisierbaren ethylenisch ungesättigten niedermolekularen Verbindungen, bevorzugt mehrfach ethylenisch ungesättigten Verbindungen vor, deren Art und Menge sich nach Art der Polymerbindemittel und Art der beabsichtigten Verwendung der lichtempfindlichen Mehrschichtmaterialien richten.

Das Mengenverhältnis in der Mischung von Monomeren und polymerem Bindemittel ist dabei in weitem Umfang variierbar, es beträgt bevorzugt 10 bis 55 und insbesondere 25 bis 50 Gew.-% an Monomeren und 45 bis 90 und insbesondere 50 bis 75 Gew.-% an polymerem Bindemittel, bezogen auf die Summe der Mengen von Monomeren und polymeren Bindemitteln. Die bevorzugten Schichten R sind bei Raumtemperatur fest und haben Stärken von 200 bis 1200 µm. Der Gehalt an bekannten Fotoinitiatoren, die bei Einwirkung von aktinischem Licht Radikale zu bilden vermögen, beträgt im allgemeinen 0,01 bis 15 Gew.-% der Gesamtmenge der Schicht R.

Als Trägerschichten (T) seien beispielhaft genannt Stahlbleche, Aluminiumbleche, Kunststoffolien wie solche aus Polyestern wie Polyethylenterephthalat, Polycarbonat, Polyvinylchlorid oder Polyamid.

Meist hat es sich als recht zweckmäßig erwiesen, die Trägerschicht (T) vor dem Auftragen der Haftschicht HO mit einer ersten Grundierlackschicht (HG) zu versehen. Hierfür lassen sich die verschiedenen Grundierlackschichten (HG) verwenden, soweit diese eine hinreichende Haftung zwischen Trägermaterial T und der Haftschicht HO vermitteln und, soweit erforderlich, bei Temperaturen getrocknet bzw. eingebrannt werden können, bei denen die Eigenschaften des Trägermaterials T thermisch nicht geschädigt werden.

Als meist sehr geeignet erwiesen sich pigmentierte und unpigmentierte Grundierlackschichten, die aus Reaktivlacken hergestellt wurden, die Polyisocyanate und hydroxylgruppenhaltige Oligomere und Polymere wie hydroxylgruppenhaltige Epoxidharze und/oder hydroxylgruppenhaltige Polyester (bevorzugt mit Molekulargewichten von 20 000 bis 30 000) oder deren Mischungen mit anderen Polyolen, z. B. 1,4-Butandiol, enthalten. Zur Herstellung der Grundierlackschicht HG wird z. B. der fertig abgemischte Grundierlack mit einem Feststoffgehalt von 20 – 70 Gew.-%, auf das Trägermaterial (T) in einer solchen Stärke aufgebracht, daß eine Trockenschichtstärke von 3 – 100 µm, vorzugsweise 5 – 20 µm erzielt wird. Die Beschichtung kann mit Hilfe einer der üblichen Techniken wie Streichen, Spitzen, Tauchen, Gießen oder Walzenauftrag erfolgen. Danach kann die Beschichtung je nach Trägermaterial bei Temperaturen zwischen 50 und 300° C getrocknet bzw. eingebrannt werden.

Zur Herstellung der Haftschichten HO werden die erfindungsgemäß verwendeten ungehärteten Mischungen in Form ihrer Lösungen auf den bevorzugt mit der Grundierlackschicht versehenen Träger in solchen Schichtstärken aufgetragen, daß sich zweckmäßigerweise eine Trockenfilmstärke von 3 bis 25 µm und insbesondere 5 bis 15 µm einstellt. Die Beschichtung kann ebenfalls durch Streichen, Spritzen, Tauchen, Gießen oder Walzenauftrag erfolgen. Zweckmäßigerweise wird die Lackschicht vorgetrocknet, bevor sie — bevorzugt ohne Härtungskatalysatoren — bei 60 bis 120 und bevorzugt bei 70 bis 90° C gehärtet bzw. eingebrannt wird.

Danach werden die Schichten R mit Vorteil aufkaschiert, wobei das Kaschierlösungsmittel von den Bindemitteln in den Schichten R bestimmt ist.

Die erfindungsgemäßen Mehrschichtenmaterialien eignen sich besonders zur Herstellung von Reliefformen bzw. Reliefdruckformen. Die Platten lassen sich z. B. in bekannter Weise zu Druckklischees verarbeiten, indem sie nach evtl. nicht-bildmäßiger Vorbelichtung (ohne Vernetzung der lichtempfindlichen Schicht R) durch ein geeignetes Negativ bildmäßig belichtet, durch Auswaschen mit Wasser bzw. einem geeignetem Lösungsmittelgemisch entwickelt und schließlich gegebenenfalls nicht-bildmäßig nachbelichtet und getrocknet werden. Zur Vorbelichtung, Bildbelichtung und Nachbelichtung eignen sich die üblichen aktinische Strahlung emittierenden Lichtquellen wie Kohlenbogenlampen, Quecksilberdampflampen, Xenonlampen oder Leuchtstoffröhren. Die Plattenentwicklung kann durch Aufsprühen des Lösungsmittels mit Hilfe eines geeigneten Düsensystems oder durch Ausreiben mit Plüsch oder geeigneten Bürsten (aufgebracht auf rotierenden und/oder oszillierenden Tellern, Walzen oder Bändern) im Lösungsmittel durchgeführt werden. Die Klischeetrocknung bzw. Nachhärtung erfolgt am zweckmäßigsten durch Aufblasen von Heißluft und/oder Beaufschlagung mit Infrarotstrahlung.

Die in den nachstehenden, die Erfindung erläuternden Beispielen und Vergleichsversuchen angegebenen Teile und Prozente beziehen sich, soweit nicht anders angegeben, auf das Gewicht.

## Beispiel 1

### 1.1 Herstellung der Grundierlackschicht HG

243 Teile eines handelsüblichen Epoxidharzes (hergestellt aus Bisphenol A und Epichlorhydrin) mit einem Epoxidäquivalent von ca. 0,02 (bezogen auf 100 g Harz), einem Molekulargewicht von ca. 5500 und einem OH-Gehalt von 5,9% sowie 147 Teile feinteiliges Lithopone (ZnS-Gehalt 60%), 3 Teile feinteiliges Rutil, 6 Teile feinteiliges Chromoxidgrün, 90 Teile Talkum und 20 Teile einer handelsüblichen Paste eines mit organischen Ammoniumbasen modifizierten Bentonits werden mit Butylacetat, Äthylglykolacetat und Xylol in einer Kugelmühle 2 Tage lang angerieben.

In den resultierenden Stammlack werden 346 Teile eines handelsüblichen Umsetzungsproduktes aus 1 Mol 1,1,1-Trimethylolpropan und 3 Molen Toluylendiisocyanat als Polyisocyanat (A3) in Form der 75%igen Lösung in Xylol/Äthylglykolacetat (Teilverhältnis 1 : 1) sowie 4 Teile einer 1%igen Lösung von Dibutylzinndilaurat in Tetrahydrofuran eingemischt. Der resultierende Lack wird auf eine biaxial gereckte Polyäthylenterephthalatfolie von 70 µm Dicke schichtförmig aufgegossen. Die Lackschicht wird 1 h bei Raumtemperatur abgelüftet und danach 5 min im Umlufttrockenschrank bei 100° C eingebrannt. Die Trockenfilmstärke der resultierenden Grundierlackschicht HG beträgt ca. 12 µm.

### 12. Herstellung der Haftschicht HO

341 Teile eines Copolyamids aus etwa gleichen Teilen Hexamethylendiammoniumadipat, 4,4′-Diammonium-di-cyclohexylmethanadipat und ε-Caprolactam mit einem K-Wert (Fikentscher, Cellulosechemie 13 (1932) 58) von 67 sowie 65 Teile eines handelsüblichen, härtbaren methanolveretherten Melamin-Formaldehyd-Kondensats mit einem mittleren Molekulargewicht von etwa 280 (hergestellt durch Reaktion von Melamin mit überschüssigem Formaldehyd in Gegenwart von Methanol in schwach saurem Medium, Melamin-Methylolierungsgrad 100%, Veretherungsgrad der Methylolgruppen ca. 50%) werden in Alkohol bei Raumtemperatur gelöst. Mit einem Gießer wird die Lösung so auf das mit der Grundierlackschicht HG versehene Trägerblech schichtförmig aufgetragen, daß eine Trockenfilmdicke von ca. 7 µm resultiert. Nach ca. 30 min Ablüften bei Raumtemperatur wird 4 min im Umlufttrockenschrank bei 90 – 108° C gehärtet.

### 1.3 Auftragen der lichtempfindlichen Schicht R

Einer 65%igen Lösung eines Gemischs von 60% des unter 1.2 angegebenen Copolyamids, 25% des Diäthers aus 1 Mol Äthylenglykol und 2 Molen N-Hydroxymethyl-acrylamid, 13,5% Benzolsulfonamid und 1,5% Benzointetrahydropyranyläther werden 0,3% des Kaliumsalzes des N-Nitrosocyclohexylhydroxylamins sowie 0,01% eines schwarzen Farbstoffs (Color-Index Nr. 12195) zugegeben. Die Lösung wird schichtförmig auf die gemäß 1.1 und 1.2 mit den Haftschichten versehene Polyesterfolie so aufgegossen, daß nach dem Trocknen bei etwa 70° C eine lichtempfindliche Schicht R mit einer Stärke von 600 µm entsteht.

### 1.4 Prüfung der Mehrschichtenmaterialien

Das Mehrschichtenmaterial wird bildmäßig belichtet und die Mindestbelichtungszeit bestimmt, die zur guten Ausbildung eines freistehenden Reliefpunktes von 200 µm um Durchmesser im Negativ erforderlich ist. Sie beträgt 3,5 min.

Aus einer Vollfläche wird vor und nach dem Auswaschprozeß je ein Streifen von 2 cm Breite herausgeschnitten. Daran wird mittels einer Federwaage die Haftkraft zwischen der belichteten Reliefschicht (R) und der Polyesterfolie als Trägerschicht (T) ermittelt. Sie beträgt vor und nach dem Auswaschprozeß jeweils etwa 3500 bis 4000 Pond.

### Vergleichsversuch 1

Es wird exakt wie in Beispiel 1 verfahren, jedoch wird zur Herstellung der Haftschicht HO gemäß 1.2 statt des Melamin-Formaldehyd-Harzes die gleiche Menge eines härtbaren Phenolharzes (hergestellt durch Kondensation von 30 Teilen Phenol und 7,5 Teilen Bisphenol A mit überschüssigem Formaldehyd bei 100° C in Gegenwart von Dimethylethanolamin) verwandt.

Die Mindestbelichtungszeit gemäß 1.4 beträgt 4,5 min. Die Haftung vor dem Auswaschprozeß beträgt etwa 2600 Pond, nach dem Auswaschprozeß sind alle feinen Reliefelemente nicht mehr vorhanden, große Volltonflächen lassen sich mit etwa 20 bis 50 Pond ablösen. Die Haftschicht (HO) ist nach dem Auswaschprozeß nicht mehr vorhanden, ein Zeichen dafür, daß sie nicht gehärtet bzw. vernetzt war.

### Beispiel 2

Es wird exakt wie in Beispiel 1 verfahren, nur wird die Grundierlackschicht (HG) nicht pigmentiert, d. h., sie besteht nur aus 243 Teilen des Epoxidharzes, 346 Teilen des Polyisocyanats und 4 Teilen einer 1%igen Lösung von Dibutylzinndilaurat.

Damit werden die gleichen Haftkraftwerte wie im Beispiel 1 erzielt.

### Beispiel 3

#### 3.1 Herstellung der Grundierlackschicht HG

100 Teile eines Polyurethans aus einem linearen, gesättigten Polyester mit einem mittleren Molekulargewicht von 1600 und einem Hydroxylgehalt von etwa 1,3% und 4,4'-Cyclohexylphenylmethandiisocyanat und 50 Teile des in Beispiel 1 eingesetzten Polyisocyanats werden zu einer 10%igen Lösung in einem Lösungsmittelgemisch aus 7 Teilen Tetrahydrofuran und 3 Teilen Methylethylketon verarbeitet. Die Lösung wird mit 1,4 Teilen einer 1%igen Lösung von Dibutylzinndilaurat in Tetrahydrofuran versetzt und dann auf eine sandgestrahlte 90 μm starke Polyesterfolie aufgetragen. Die beschichtete Folie wird nach 20 min Ablüften 10 min lang auf 90°C erwärmt. Die resultierende Grundierlackschicht HG hat eine Schichtdicke von 8 μm.

#### 3.2 Herstellung der Haftschicht HO

Auf die mit der Grundierlackschicht HG versehene Folie wird dann eine Haftschicht HO aus 175 Teilen eines elastomeren Styrol-Isopren- Styrol-Dreiblockcopolymeren und 68 Teilen des in Beispiel 1 verwendeten Melamin-Formaldehyd-Kondensats, gelöst in Toluol, aufgebracht. Nach 30 min Ablüften bei Raumtemperatur wird die Schicht 5 min bei 100°C gehärtet. Die Schichtdicke der Haftschicht HO beträgt 15 μm.

#### 3.3 Auftragen der lichtempfindlichen Schicht R

Eine Schicht aus 80 Teilen des bei 3.2 angegebenen Blockcopolymeren als Bindemittel, 15 Teilen 1,4-Butandiol-dimethacrylat, 1,7 Teilen Benzoinmethylether und 0,3 Teilen Hydro- chinonmonomethylether wird auf die Haft- schicht HO aufkaschiert und das resultierende Mehrschichtmaterial 3 Tage bei Raumtemperatur gelagert.

#### 3.4 Prüfung der Mehrschichtenmaterialien

Die Prüfung erfolgt wie bei 1.4 angegeben. Folgende Haftkraftwerte werden ermittelt:

Vor dem Auswaschen:  1400 Pond,
nach dem Auswaschen:  900 – 1000 Pond.

Die Haftkraft ist dauerhaft.

### Vergleichsversuch 2

Es wird exakt wie in Beispiel 3 verfahren. Anstelle des Melamin-Formaldehyd-Kondensats wird das im Vergleichsversuch 1 angegebene Phenol-Formaldehyd-Kondensat eingesetzt. Es ergeben sich Haftkraftwerte von etwa 1200 Pond vor dem Auswaschprozeß, und 20 bis 40 Pond nach dem Auswaschprozeß, wobei feine Relief- elemente schon während des Auswaschprozes- ses weggewaschen werden.

### Beispiel 4

Es wird exakt wie in Beispiel 1 verfahren, jedoch anstelle des Lithopone wird Rutil verwendet und anstelle der Polyesterfolie wird ein Stahlblech mit der Dicke von 240 μm als Trägerschicht verwendet.

Sowohl die Grundierlackschicht HG als auch die Haftschicht HO werden je 4 Minuten bei 140°C in einem Umlufttrockenschrank gehärtet bzw. eingebrannt.

Die Haftkraftwerte betragen vor und nach dem Auswaschprozeß mehr als 6000 Pond.

### Vergleichsversuch 3

Es wird exakt wie in Beispiel 4 verfahren. Anstelle des Melamin-Formaldehyd-Kondensats wird das im Vergleichsversuch 1 angegebene Phenol-Formaldehyd-Kondensat eingesetzt. Um die gleichen Haftwerte wie im Beispiel 4 zu erreichen, muß die Haftschicht HO 6 min bei 240°C eingebrannt werden. Damit erbringen die erfindungsgemäßen Haftlacke eine deutliche Energieeinsparung.

### Beispiel 5

Es wird wie in Beispiel 1 verfahren, nur wird die Grundierlackschicht HG aus 97 Teilen eines gesättigten Polyesters mit einem mittleren Molekulargewicht von ca. 25 000 und einer OH-Zahl von 2 bis 3 und 2,25 Teilen 1,3,5-Tris(6- isocyanatohexyl)biuret hergestellt. Es werden folgende Haftkraftwerte erreicht: vor dem Auswaschen: ca. 3000 Pond, nach dem Auswa-

schen 2800 bis 3100 Pond.

**Patentansprüche**

1. Lichtempfindliches Mehrschichtenmaterial, das zwischen

(a) einer gegebenenfalls mit einer Grundierlackschicht (HG) versehenen Trägerschicht (T) und
(b) einer lichtempfindlichen Schicht R mit einer Fotoinitiator enthaltenden Mischung von mindestens einem polymeren Bindemittel und mindestens einer damit verträglichen fotopolymerisierbaren ethylenisch ungesättigten niedermolekularen Verbindung,
(c) eine der lichtempfindlichen Schicht R benachbarte Haftschicht HO mit einer gehärteten Mischung eines Bindemittels aufweist, dadurch gekennzeichnet, daß die Haftschicht HO eine gehärtete Mischung aus

(A1) 65 bis 98 Gew.-% eines mit dem Bindemittel der Schicht R und dem Kondensat (A2) verträglichen Bindemittels und
(A2) 2 bis 35 Gew.-% eines bei 60 bis 120°C härtbaren 1 bis 5 Melamin-Einheiten enthaltenden Melamin-Formaldehyd-Kondensats mit einem Methylolierungsgrad des Melamins von 40 bis 100%, wobei 10 bis 60% der Methylolgruppen mit Alkohol verethert sind, enthält.

2. Verfahren zum Herstellen einer Haftschicht HO eines lichtempfindlichen Mehrschichtenmaterials, das zwischen

(a) einer gegebenenfalls mit einer Grundierlackschicht (HG) versehenen Trägerschicht (T) und
(b) einer lichtempfindlichen Schicht R mit einer Fotoinitiator enthaltenden Mischung von mindestens einem polymeren Bindemittel und mindestens einer damit verträglichen fotopolymerisierbaren ethylenisch ungesättigten niedermolekularen Verbindung,
(c) eine der lichtempfindlichen Schicht R benachbarte Haftschicht HO mit einer gehärteten Mischung eines Bindemittels aufweist,

durch schichtförmiges Auftragen eines Lackes (OL) mit einer härtbaren Mischung eines Bindemittels auf die gegebenenfalls mit einer Grundierlackschicht (HG) versehenen Trägerschicht (T), Trocknen und Einbrennen der Lackschicht zur Haftschicht HO, dadurch gekennzeichnet, daß der Lack (OL) als Bindemittel eine Mischung aus

(A1) 65 bis 98 Gew.-% eines mit dem Bindemittel der Schicht R und dem Kondensat (A2) verträglichen Bindemittels und
(A2) 2 bis 35 Gew.-% eines bei 60 bis 120°C härtbaren 1 bis 5 Melamin-Einheiten enthaltenden Melamin-Formaldehyd-Kondensats mit einem Methylolierungsgrad des Melamins von 40 bis 100%, wobei 10 bis 60% der Methylolgruppen mit Alkohol verethert sind, enthält und die Mischung nach dem Auftragen der Lackschicht durch Erwärmen gehärtet wird.

**Claims**

1. A photosensitive multi-layer material which has between

(a) a base B optionally provided with an adhesion-promoting layer APL, and
(b) a photosensitive layer R comprising a mixture containing at least one polymeric binder, at least one photopolymerizable ethylenically unsaturated low molecular weight compound compatible therewith and a photoinitiator,
(c) an adhesive layer AL, adjacent to the photosensitive layer R, comprising a hardened binder mixture, wherein the adhesive layer AL contains a hardened mixture consisting of

(A1) 65 − 98% by weight of a binder which is compatible with the binder of the layer R and with the condensate (A2), and
(A2) 2 − 35% by weight of a melamine-formaldehyde condensate, hardenable at 60 − 120°C, which contains 1 − 5 melamine units and has a degree of methylolation of the melamine of 40 − 100%, 10 − 60% of the methylol groups being etherified with an alcohol.

2. A process for the preparation of an adhesive layer AL of a photosensitive multi-layer material which has between

(a) a base B optionally provided with an adhesion-promoting layer APL, and
(b) a photosensitive layer R comprising a mixture containing at least one polymeric binder, at least one photopolymerizable ethylenically unsaturated low molecular weight compound compatible therewith and a photoinitiator,
(c) an adhesive layer AL, adjacent to the photosensitive layer R, comprising a hardened binder mixture,

by applying a layer of an adhesive A comprising a hardenable binder mixture to the base B optionally provided with an adhesion-promoting layer APL, and drying and baking the layer of adhesive to form the adhesive layer AL, wherein the adhesive A contains, as binder, a mixture of

(A1)     65 – 98% by weight of a binder which is compatible with the binder of the layer R and with the condensate (A2), and

(A2)     2 – 35% by weight of a melamine-formaldehyde condensate, hardenable at 60 – 120°C, which contains 1 – 5 melamine units and has a degree of methylolation of the melamine of 40 – 100%, 10 – 60% of the methylol groups being etherified with an alcohol, and the mixture, after application of the layer of adhesive, is hardened by heating.

**Revendications**

1. Matériau multicouche photosensible qui comporte, entre

a)     une couche support (T), éventuellement munie d'une sous-couche de laque (HG) et

b)     une couche photosensible (R) d'un mélange, contenant un photoinitiateur, d'au moins un liant polymère et d'au moins composé de faible poids moléculaire, à insaturation éthylénique, photopolymérisable et compatible avec le précédent,

c)     une couche d'adhérence (HO), contiguë à la couche photosensible (R), d'un mélange durci d'un liant, caractérisé par le fait que la couche d'adhérence Ho contient un mélange durci de

(A1)     65 à 98% en poids d'un liant compatible avec le liant de la couche R et avec le condensat (A2) et

(A2)     2 à 35% en poids d'un condensat mélamine-formaldéhyde, durcissable entre 60 et 120°C, contenant 1 à 5 motifs mélamine, et d'un degré de méthylolation de la mélamine de 40 à 100%, 10 à 60% des groupes méthylol étant étherifiés avec de l'alcool.

2. Procédé de préparation d'une couche d'adhérence HO d'un matériau multicouche photosensible qui comporte, entre

a)     une couche support (T), éventuellement munie d'une sous-couche de laque (HG) et

b)     une couche photosensible (R) d'un mélange, contenant un photoinitiateur, d'au moins un liant polymère et d'au moins un composé de faible poids moléculaire, à insaturation éthylénique, photopolymérisable et compatible avec le précédent,

c)     une couche d'adhérence (HO), contiguë à la couche photosensible (R), d'un mélange durci d'un liant,

par application, en couche, d'une laque (OL) d'un mélange durcissable d'un liant sur la couche support (T), éventuellement munie d'une sous-couche de laque (HG), séchage et cuisson de la couche de laque, pour obtention de la couche d'adhérence HO, caractérisé par le fait que la laque (OL) contient, comme liant, un mélange de

(A1)     65 à 98% en poids d'un liant compatible avec le liant de la couche R et avec le condensat (A2) et

(A2)     2 à 35% en poids d'un condensat mélamine-formaldéhyde, durcissable entre 60 et 120°C, contenant 1 à 5 motifs mélamine, et d'un degré de méthylolation de la mélamine de 40 à 100%, 10 à 60% des groupes méthylol étant étherifiés avec de l'alcool, et le mélange, après application de la couche de laque, est durci par chauffage.